Europäisches Patentamt

European Patent Office

Office européen des brevets

(19)

(11) EP 0 656 685 B1

(12) FASCICULE DE BREVET EUROPEEN

(45) Date de publication et mention
de la délivrance du brevet:
09.09.1998  Bulletin 1998/37

(51) Int Cl.⁶: H03F 3/08, H03F 1/34

(21) Numéro de dépôt: 94402753.1

(22) Date de dépôt: 01.12.1994

(54) **Dispositif d'amplification à rétroaction**

Verstärkervorrichtung mit Rückkopplung

Amplifier arrangement with feedback

(84) Etats contractants désignés:
DE GB

(30) Priorité: 03.12.1993  FR 9314533

(43) Date de publication de la demande:
07.06.1995  Bulletin 1995/23

(73) Titulaire: FRANCE TELECOM
75015 Paris (FR)

(72) Inventeur: Legros, Eric
F-94300 Vincennes (FR)

(74) Mandataire: Martin, Jean-Jacques et al
Cabinet REGIMBEAU
26, Avenue Kléber
75116 Paris (FR)

(56) Documents cités:
WO-A-80/02484          US-A- 4 590 434
US-A- 4 998 012

## Description

La présente invention est relative à un dispositif d'amplification à rétroaction.

L'invention trouve avantageusement plus particulièrement application, dans le domaine des télécommunications optiques, pour la préamplification d'un signal en sortie d'un photodétecteur. D'autres applications de l'invention sont bien entendu possibles. En particulier, l'invention s'applique également avantageusement dans le domaine de l'instrumentation pour amplifier un signal avec un faible bruit et une bonne sensibilité.

Classiquement, un circuit pour la transformation d'un signal en sortie d'un photodétecteur comporte un étage d'entrée, dit étage de préamplification, qui fixe le rapport signal/bruit du signal transformé par le circuit.

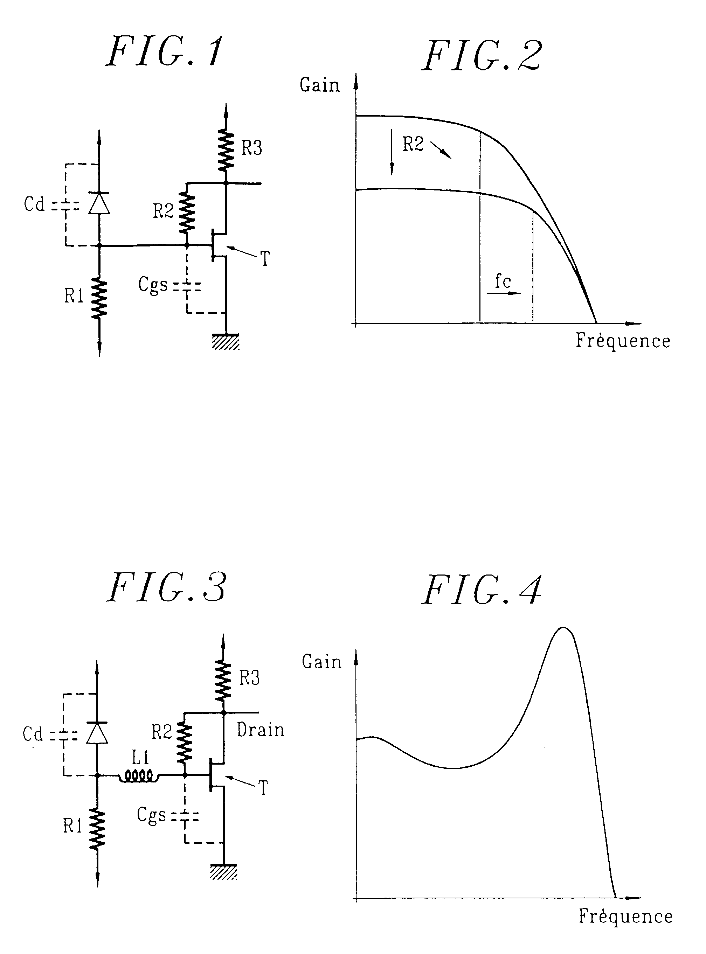

On a représenté sur la figure 1 le schéma d'un étage de préamplification, d'un type classiquement utilisé à ce jour. Les moyens d'amplification y sont constitués par un transistor T à effet de champ polarisé avec une tension de grille négative (pour un canal de type N) de façon à limiter le courant sur la grille et le bruit de grenaille qui y est associé.

Du point de vue électrique, le photodétecteur correspond essentiellement à une capacité Cd, tandis que l'impédance d'entrée du transistor T est, au premier ordre, une capacité Cgs.

Sur le drain du transistor est montée une résistance R3.

Sur la grille, il est monté une résistance R1 qui sert à polariser la photodiode en inverse et à évacuer le photocourant continu.

Dans le cas où aucun élément n'est monté en réaction entre la grille et le drain du transistor T, à basse fréquence, le gain transimpédance de l'étage est, ainsi qu'on l'a illustré sur la figure 2, constant et égal à $g_m$ R1 R3, où $g_m$ est la transductance du transistor.

A plus haute fréquence, au-delà d'une fréquence de coupure $f_c$ égale à $1/2\pi R1(C_d+C_{gs})$, la réponse de l'étage de préamplification décroît en gain proportionnellement à 1/f, tandis que la densité de bruit équivalente en entrée croît en $f^2$, où f est la fréquence du signal d'entrée.

L'on sait de façon classique qu'il est possible de déplacer la fréquence de coupure de l'étage de préamplification en montant entre la grille et le drain du transistor T une résistance R2 de rétroaction. Cette résistance R2 permet de ramener sur la grille une impédance de valeur R2/(1+$g_m$R3). En faisant décroître la valeur de R2, la courbe de gain est déplacée ainsi qu'indiqué par les flèches sur la figure 2.

Néanmoins, le bruit thermique engendré par cette résistance R2 de rétroaction est proportionnel à kT/R2, où k est la constante de Boltzmann et où T est la température absolue. Le choix de la fréquence de coupure impose donc un niveau de bruit qui est d'autant plus important que cette fréquence de coupure est élevée.

Pour réduire le bruit de l'étage de préamplification et augmenter la fréquence de coupure, il a déjà été proposé de compenser la capacité Cgs équivalente du transistor et la capacité Cd équivalente de la diode par un ou plusieurs éléments inductifs montés en parallèle ou en série. On pourra à cet égard avantageusement se référer aux différentes publications suivantes :

-   "Fiber-Optic Multigigabit GaAs MIC Front-End Circuit with Inductor Peaking" - NORIO OHKAWA - Journal of Lightwave Technology, Vol. 6, N0. 11. November 1988 IEEE, pages 1665 - 1671 ;
-   "Tuned Front-End Design for Heterodyne Optical Receivers" - G. JACOBSEN, J.-X. KAN, and I. GARRETT, Member, IEEE - Journal of Lightwave Technology, Vol. 7 N0. 1.January 1989 IEEE, pages 105 - 114 ;
-   "Ultrawide Bandwidth Optical Receivers" - JAMES L. GIMLETT - Journal of Lightwave Technology, Vol. 7 NO. 10. October 1989 IEEE, pages 1432 - 1437.

Un exemple d'un montage de ce type est représenté sur la figure 3. Ce montage est analogue à celui de la figure 1 et comporte en outre une inductance L1 de résonance montée entre la grille du transistor T et le noeud commun à la résistance R1 et à la photodiode. Cette inductance L1 est choisie de façon que son impédance s'oppose à celles des capacités Cd et Cgs pour augmenter l'amplitude du signal présent sur le transistor. Ainsi, le rapport signal/bruit de l'étage est augmenté.

Un montage de ce type est par exemple celui décrit dans US-4 998 012 qui propose un dispositif amplificateur pour la transmission sur fibres optiques comportant une rétroaction résistive ainsi qu'une inductance parallèle d'adaptation. Un second étage tampon permet d'adapter l'impédance du signal à la sortie de 75 Ohms. La bande passante va de 50 à 500 MHz.

La réponse en gain d'un tel montage avec inductance est du type de celle qui a été représentée sur la figure 4. Cette réponse présente des ondulations de résonance et en particulier, au voisinage de la fréquence de coupure, un pic de gain. Pour les applications à la transmission de signal, il est nécessaire de pouvoir gommer ce pic.

Une solution retenue à ce jour consiste à disposer dans le montage de réception un étage supplémentaire ayant une fonction de transfert inverse de celle de l'étage de préamplification. Mais l'obtention d'une réponse plate suppose que les composants des deux étages soient parfaitement ajustés de façon à se compenser. Cette solution est par conséquent très sensible aux fluctuations technologiques. En outre, cette solution est un obstacle à l'intégration sur un composant monolithique, puisqu'elle nécessite l'intégration d'un étage d'égalisation, dont la complexité augmente avec celle de la réponse à corriger.

Cette solution est celle retenue dans US-4 998 012, dans lequel le réseau RLC 62, 64 et L3 réalise la fonction de transfert inverse. L'inductance L2 n'est qu'une inductance de choc (découplage d'alimentation).

Il a également été proposé de compenser les ondulations introduites par la résonance entre la ou les inductances et les capacités parasites du transistor, en introduisant, dans l'étage de préamplification, des résistances de compensation. Néanmoins, ces résistances augmentent le bruit du préamplificateur, ce qui est contraire à l'objectif recherché.

Un but de l'invention est donc de proposer un dispositif d'amplification à élément inductif d'accord résonant, présentant à la fois un gain d'amplification indépendant de la fréquence dans la bande où le dispositif agit et un rapport signal/bruit satisfaisant.

On connaît déjà des montages d'amplification à rétroaction par induction mutuelle entre des éléments en entrée et en sortie d'un transistor. Ces montages ont la propriété d'être, à gain égal, d'une plus grande dynamique que les montages à rétroaction résistive. On pourra à cet égard se référer aux deux publications suivantes :

- "High Dynamic Range Transistor Amplifiers using lossless Feedback" - David E. NORTON - MACROWAVE - May 76 pages 53-57 ;
- "Wide Band High Sensitivity Directional-coupler-based Front-End for Optical Receivers" - T. KORHONEN - A.B. SHARMA - ECOC 90, pages 335-338.

Dans ces montages, le couplage de rétroaction entre les éléments inductifs en entrée et en sortie du dispositif d'amplification est un couplage mutuel total : le coefficient k de couplage entre les deux éléments est voisin de 1, k étant donné par la formule :

$$Lm = k \, (L1 \; L2)^{1/2} \, ,$$

où Lm est la valeur de l'inductance mutuelle et où L1 et L2 sont les inductances des deux éléments.

Les éléments inductifs n'y sont donc aucunement prévus comme éléments résonants, compensant l'impédance capacitive d'entrée de l'amplificateur.

Les montages dont font état ces articles, sont par conséquent éloignés du problème technique à résoudre par l'invention.

En outre, on notera que dans les dispositifs de ces articles, le couplage est réalisé, soit à l'aide de coupleurs à noyaux de ferrite, qui sont difficilement intégrables dans une structure monolithique, soit au moyen de coupleurs du type directif qui présentent l'inconvénient majeur de n'être fonctionnels que sur des bandes passantes de 2 octaves au maximum et ne peuvent être par conséquent utilisés dans des techniques de télécommunications optiques, pour lesquelles l'on utilise des bandes passantes dont les fréquences de coupure haute et basse sont respectivement égales à environ 0,7 fois et $10^{-4}$ fois le débit binaire de communication.

Des montages à couplage mutuel total du type précité ont encore été proposés dans US-4 590 434 et WO-A-80 02484.

Ces deux documents proposent tous deux un contrôle du gain au moyen d'une rétroaction par couplage mutuel total : un élément actif dont le gain n'est pas très régulier (mais est grand) est inséré au milieu d'éléments passifs (transformateurs) qui sont les seuls (idéalement) à contrôler le gain de l'ensemble (réduisant par là le gain brut de l'élément actif).

Le dispositif de US-4 590 434 est plus particulièrement adapté à l'amplification de signaux à impédance fixe ZO, par exemple de 50 ou de 75 Ohms. Pour ce type de signaux, la tension et l'intensité du véhicule des informations avec le même poids doivent être traitées à part égale. L'énergie d'un signal d'impédance ZO doit en principe être totalement dissipée dans une charge d'impédance ZO pour éviter qu'une partie du signal ne retourne vers la source et provoque des réflexions multiples le long des câbles, ces réflexions étant nuisibles à l'obtention d'un gain plat sur de larges bandes passantes.

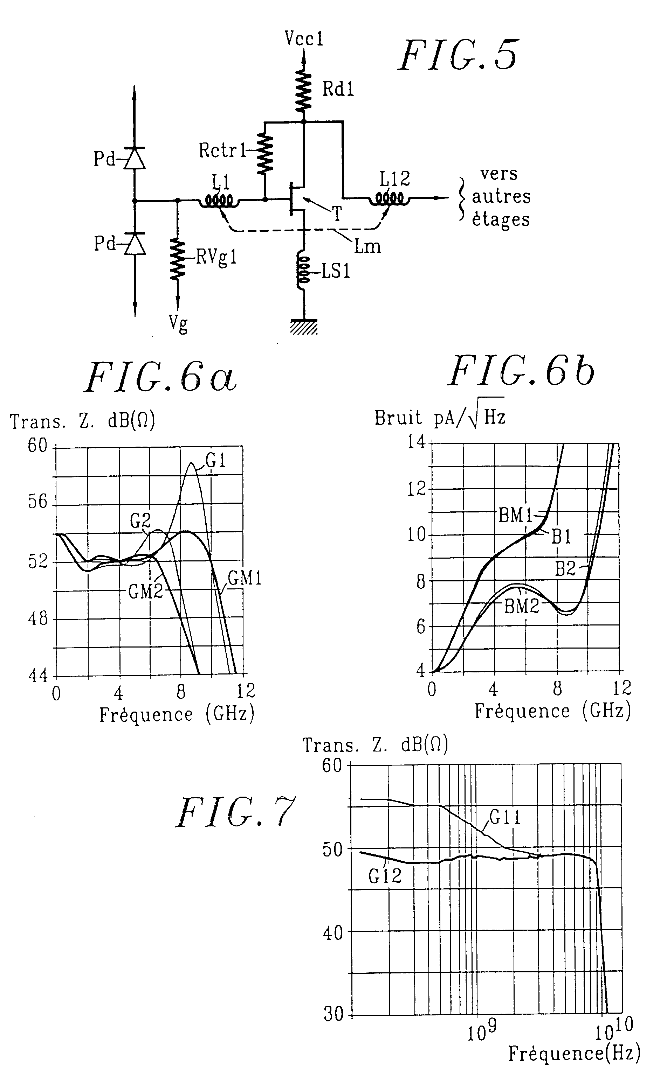

Dans US-4 590 434, on utilise des transformateurs pour transférer cette énergie vers le canal de sortie, en lui ajoutant l'énergie du dispositif actif d'amplification (transistors bipolaires des figures 5 et 6). Deux transformateurs servent à extraire parallèlement les informations de courant et de tension du signal incident et à assurer un rapport constant (c'est-à-dire indépendant de la fréquence et du gain propre des transistors) entre les courants de sortie et d'entrée d'une part, et les tensions de sortie et d'entrée d'autre part.

Dans WO-A-80 02484, il est proposé d'établir un rapport constant entre le courant de sortie et la tension d'entrée en contrôlant l'intensité qui traverse le haut-parleur. La rétroaction par couplage mutuel total y a pour but d'assurer une proportionnalité entre le courant de sortie de l'amplificateur et la tension qui constitue le signal d'entrée.

US-4 590 434 et WO-A-80 02484 mettent par conséquent tous deux en oeuvre une ou plusieurs rétroactions mutuelles totales entre une ou plusieurs grandeurs de sortie et d'entrée (intensité et/ou tension).

L'invention propose pour sa part un dispositif à large bande passante pour l'amplification d'un signal électrique, comportant des moyens d'entrée recevant ce signal, un amplificateur à l'entrée duquel ces moyens sont reliés, des moyens pour réaliser une rétroaction entre un signal en sortie de l'amplificateur et le signal en entrée de celui-ci, les moyens d'entrée présentant une impédance self-inductive de résonance, caractérisé en ce que les moyens de rétroaction comportent des moyens reliés à la sortie de l'amplificateur, qui sont couplés par induction mutuelle partielle aux moyens d'entrée et qui atténuent, au moins en partie, le pic de résonance de la réponse en gain du dispositif au voisinage de la fréquence de coupure.

Le couplage partiel entre l'inductance de sortie et l'inductance d'entrée, de la solution proposée par l'invention, n'a pas pour fonction de contrôler le gain dans sa totalité, mais de générer l'équivalent d'une inductance globale dont la résonance avec les capacités parasites est amortie, sans augmentation de bruit.

La réalisation d'un tel amortissement avec une résistance augmenterait le bruit équivalent du dispositif.

En outre, un autre avantage du couplage mutuel partiel proposé par l'invention est qu'il est réalisable sur un circuit intégré, sans utilisation d'éléments amplifiant le champ magnétique, comme c'est le cas dans un transformateur.

D'autres caractéristiques et avantages de l'invention ressortiront encore de la description qui suit d'un mode de réalisation particulier possible.

Cette description est purement illustrative et non limitative. Elle doit être lue en regard des dessins annexés sur lesquels :

- la figure 5 illustre un étage de préamplification pour photodétecteurs, conforme à ce mode de réalisation ;
- les figures 6a et 6b illustrent la réponse théorique, en fonction de la fréquence, respectivement en gain et en bruit d'un ensemble de traitement de signal comportant l'étage de préamplification représenté sur la figure 5 ;
- la figure 7 illustre la réponse en gain d'un ensemble de traitement de signal comportant un étage de préamplification du type de celui de la figure 5 ;
- les figures 8 et 9 sont des représentations de composants monolithiques comportant un étage d'amplification du type de celui de la figure 5.

Le dispositif d'amplification représenté sur la figure 5 est le premier étage d'un ensemble de traitement du signal en sortie de deux photodiodes Pd, montées en parallèle de façon à constituer un photorécepteur cohérent, pour la réjection du bruit de l'oscillateur local.

Cet étage amplifie le photocourant et est complété par deux autres étages (non représentés pour ne pas surcharger les figures), l'un qui permet de diminuer l'impédance de l'ensemble et joue un rôle d'égalisation de tension, l'autre étant un suiveur de tension, les trois étages permettant de faire passer l'impédance de sortie de 250 à 50 Ohms.

Le dispositif de préamplification conforme à l'invention comprend un transistor T à effet de champ dont la capacité équivalente entre la grille et la source est de 250 femtofarads et dont la transconductance se situe aux alentours de 85 mS.

La source de ce transistor est reliée à la masse, par l'intermédiaire d'une inductance LS1 modélisant l'impédance des connexions vers la masse.

Sur le drain de ce transistor sont montés, d'une part, le deuxième étage d'amplification et, d'autre part, une résistance Rd1 ayant pour valeur 350 Ohms.

La grille de ce transistor T est polarisée négativement (tension Vg), par l'intermédiaire d'une résistance RVg1 en série avec une self-inductance L1 de résonance. RVg1 a une valeur de 5 kOhms. L1 est destinée à compenser les capacités parasites des photodiodes Pd et du transistor T et a pour valeur 2,1 nH.

En entrée du deuxième étage d'amplification, entre la grille du transistor de celui-ci, et le drain du transistor T est montée une inductance L12 de valeur 1,9 nH.

Entre le drain et la grille de ce même transistor, est montée une résistance de rétroaction Rctr1 de 2 kOhms.

Les deux photodiodes Pd sont branchées en parallèle sur l'entrée de l'inductance L1.

Conformément à l'invention, les deux inductances L1 et L12 sont partiellement couplées mutuellement. Par couplage mutuel partiel, on entend un couplage non total avec une valeur de coefficient de couplage k substantiellement inférieure à 1. Préférentiellement, k est inférieur à 0,5 de façon que l'inductance L1 joue son rôle de résonance, et est supérieur à 0,01 de façon que la rétroaction inductive soit efficace.

Dans l'exemple préféré décrit, l'inductance mutuelle Lm a pour valeur 0,3 nH, ce qui correspond à une valeur de coefficient de couplage k égale à 0,1.

Les valeurs de capacités Cd équivalentes des photodiodes Pd sont choisies du même ordre de grandeur que la capacité équivalente Cgs entre la grille et la source du transistor T de façon à ce que l'étage présente à la fois un gain satisfaisant et un bruit peu important.

La bande passante du dispositif de la figure 5 est de 9 GHz après égalisation de la réponse BF.

Sur la figure 6a ont été représentées quatre courbes de gain en fonction de la fréquence, référencées respectivement par G1, G2, GM1, GM2.

Les courbes G1 et GM1 sont les courbes calculées du gain d'un ensemble de traitement de signal comportant un étage de préamplification correspondant au dispositif de la figure 5, respectivement avec et sans rétroaction par mutuelle inductance, pour des valeurs de capacités Cd égales à 100 fF.

Les courbes G2 et GM2 sont des courbes analogues aux courbes G1 et GM1, pour des valeurs de capacités équivalentes de diodes égales à 300 fF.

On voit sur ces courbes que les pics de gain de résonance que présentent les courbes G1 et G2 sont fortement atténués sur les courbes GM1 et GM2.

La réponse en gain de l'ensemble de traitement dont l'étage de préamplification présente une rétroaction par mutuelle inductance est sur la courbe GM1 sensiblement identique à celle de la courbe G1 jusqu'à 1/3 de la fréquence de coupure (à basses fréquences, c'est la rétroaction résistive qui contrôle la réponse), tandis qu'au voisinage de la fréquence de coupure, le pic est supprimé (pour les fréquences allant de 2/3 de la fréquence de coupure à la fréquence de coupure, c'est la rétroaction par mutuelle inductance qui contrôle la réponse).

La valeur de la résistance Rctr1 a volontairement été choisie importante, ce qui laisse subsister une remontée de la réponse en basse fréquence. Cette résistance Rctr1 produit le plateau de gain en dessous de 1 GHz, le deuxième étage de l'ensemble de traitement procurant l'égalisation basse fréquence qui compense l'excès de gain basse fréquence du premier étage.

Sur la courbe GM2, on a volontairement laissé subsister un léger pic au voisinage de la fréquence de coupure. Ce pic est destiné à compenser les pertes de signal des étages ultérieurs, pour les fréquences proches de la fréquence de coupure.

Les courbes B1, BM1, B2 et BM2 représentées sur la figure 6b sont les courbes de bruit en fonction de la fréquence correspondant aux courbes de gain de la figure 6a. Ainsi que l'on peut le voir sur ces figures, le bruit de l'ensemble de traitement n'est pas modifié par la rétroaction mutuelle : les courbes B1 et B2 sont confondues respectivement aux courbes BM1 et BM2.

Ainsi, la rétroaction par couplage mutuel partiel permet, sans pertes et bruits supplémentaires, de niveler la réponse de l'ensemble de traitement pour supprimer le pic de réponse avant la fréquence de coupure.

Du point de vue dynamique, le dispositif d'amplification selon l'invention présente des caractéristiques équivalentes, voir supérieures, à celles d'un circuit à rétroaction résistive pure.

On notera qu'un avantage important de l'invention est qu'elle permet d'égaliser la réponse en gain de l'amplificateur par un moyen qui est peu sensible à une variation de la capacité équivalente d'entrée. La capacité équivalente de la ou des photodiodes peut décroître devant la capacité Cgs sans que l'efficacité de la rétroaction ne soit affectée de façon sensible. La rétroaction par couplage mutuel permet donc, à capacité Cd d'entrée fixée, d'augmenter Cgs, c'est-à-dire la largeur du transistor T, sans pour autant augmenter l'amplitude du pic dans la réponse en fin de bande passante. Le gain augmente donc, tandis que la valeur nécessaire pour l'inductance L1 diminue (pour L1Cgs constant) : les dimensions physiques de l'inductance sont donc diminuées, ce qui est un avantage important pour l'intégration sur un composant monolithique.

On se réfère maintenant à la figure 7, sur laquelle ont été représentées les courbes de gain G11 et G12 relevées expérimentalement en sortie du troisième étage de l'ensemble de traitement de signal dont fait partie le dispositif d'amplification qui vient d'être décrit. Ces courbes G11 et G12 correspondent à des ensembles de traitement dont la courbe de gain calculée est respectivement GM1, ou GM2. On voit sur cette figure 7, que la légère remontée que la courbe GM2 présente au voisinage de la fréquence de coupure permet de compenser les pertes d'énergie (courbe G11), afin d'obtenir une réponse plate en sortie du troisième étage (courbe G12).

Conformément à un aspect particulièrement avantageux de l'invention, le dispositif d'amplification qui vient d'être décrit est intégré, avec les autres étages, sur un composant monolithique.

De façon générale, le couplage mutuel peut être obtenu en faisant passer une ligne à proximité d'une inductance, ou en rapprochant deux inductances l'une de l'autre. Il peut aussi correspondre à un couplage entre deux lignes. L'absence d'élément spécifique autre que les lignes (ou inductances) interétages fait que cette rétroaction ne demande pas a priori de place supplémentaire sur le circuit, et la rend donc intéressante pour des applications intégrées. La rétroaction peut être réalisée sans utiliser d'élément passif ajouté au monolithe (élément dessiné sur un substrat support du monolithe par exemple).

Les inductances L1, L12 sont des rubans d'une largeur de l'ordre du micron, déposés sur un substrat S. Le choix du matériau du substrat S dépend de l'application à laquelle ce circuit est destiné, ainsi que de la technologie de réalisation choisie. Le substrat S est par exemple un substrat de quartz épais, ou même un substrat de GaAs ou de InP, sur lequel les inductances L1, L12 sont déposées par lithographie directe ou inverse (lift off).

Le couplage mutuel entre ces deux inductances est réalisé en jouant sur la géométrie et la disposition relative des deux rubans.

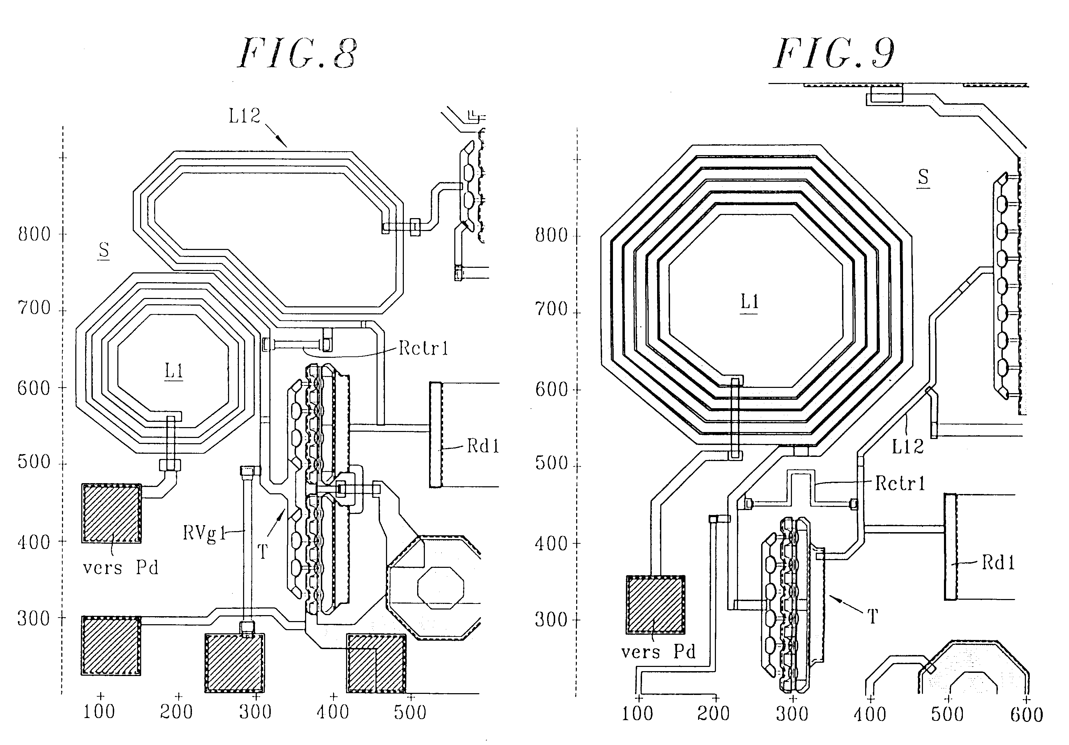

On a représenté sur la figure 8 un exemple de géométries et de disposition relative utilisées pour réaliser le dispositif d'amplification précédemment décrit en référence aux figures 5 à 7. On retrouve sur cette figure 8, le transistor T (constitué de deux transistors en parallèle), les résistances Rctr1 et Rd1, ainsi que les rubans d'inductances L1 et L12 déposés sur un substrat S. Des graduations de dimensionnement sont portées en abscisse et en ordonnée de la figure 8, l'unité de l'échelle étant le micromètre.

Le ruban de l'inductance L1 a une forme octogonale, avec une largeur W de 15 $\mu$m et un espacement G entre les spires de 5 $\mu$m. Il est souhaitable de prendre un rapport W/G aussi grand que possible afin de minimiser la résistance série de l'inductance (génératrice de bruit thermique).

Dans le cas de L12, la largeur des spires est de 10 $\mu$m, la distance entre spires est également de 10 $\mu$m. La résistance série est ici sans importance.

Deux segments successifs de L12 sont parallèles à deux côtés de L1, et en sont écartés d'environ 7,5 $\mu$m.

Un autre exemple de réalisation d'un composant monolithique a été représenté sur la figure 9. L1 et L12 y ont respectivement pour valeur environ 12 nH et 0,4 nH. Leur inductance mutuelle Lm est de 0,3 nH (coefficient k de couplage égal à 0,136).

La largeur des spires de L1 et l'écart entre celles-ci sont les mêmes que dans la réalisation de la figure 8.

Le ruban L12 est une simple ligne disposée à proximité de L1, et s'étendant selon deux segments parallèles à deux côtés successifs de L1 et espacés de ceux-ci de 26 $\mu$m.

La bande passante de cette réalisation est de 3 GHz.

Pour les réalisations illustrées aux figures 8 et 9, le dessin de L12 a été calculé pour trouver à la fois la valeur souhaitée de L12 et de la mutuelle Lm, sachant que la forme de L1 a été choisie pour réduire au maximum la résistance série.

Le calcul des inductances a été obtenu par simulation numérique : les inductances sont modélisées comme une suite de segments. Les inductances et les mutuelles sont calculées pour chaque couple de segments, et sommées algébriquement sur l'ensemble des segments. Bien entendu, d'autres géométries que celles qui ont été représentées sur les figures 8 et 9 sont possibles pour les inductances.

Ce calcul a été fait sans tenir compte d'un déphasage des signaux (donc en très basse fréquence).

Les parties des selfs en forte interaction (proches l'une de l'autre) ont volontairement été choisies du côté du premier transistor (respectivement pour la connexion vers sa grille et vers son drain), cela afin de minimiser des déphasages parasites liés à la propagation du signal électrique le long des rubans. De tels déphasages pourraient en effet modifier la phase de la rétroaction et donc dégrader la rétroaction par mutuelle, voir même générer une oscillation du premier étage. Le sens dans lequel les inductances sont dessinées paraît donc le plus sain pour un fonctionnement correct du circuit, afin de minimiser les effets de la propagation des signaux.

A titre d'exemple de la compacité du circuit que permet de réaliser l'invention, des préamplificateurs monolithiques pour photoréception occupant $1,1 \times 1,35 \ mm^2$, compatibles avec une transmission en format NRZ jusqu'à 10 Gbit/s ont été testés avec succès (courbe de réponse Figure 7).

Bien entendu, l'invention s'applique aussi à des dispositifs d'amplification à rétroaction purement inductive et non résistive.

Le couplage mutuel peut être réalisé sur des inductances qui ne sont pas directement en sortie de l'amplificateur, mais sont en sortie d'étages en aval de celui-ci.

L'invention s'applique également à d'autres amplificateurs que ceux à transistor(s) à effet de champ et notamment aux amplificateurs à transistor(s) bipolaire(s).

Le couplage mutuel partiel peut résulter d'un couplage total entre deux éléments disposés respectivement en amont et en aval d'un amplificateur, l'élément en amont étant complété par une self-inductance pure.

On notera que le dispositif proposé par l'invention est particulièrement adapté aux larges bandes passantes (de 1 MHz à 9 GHz, dans l'exemple étudié, c'est-à-dire 4 décades).

Egalement, on notera que la rétroaction apportée dépend de la transconductance du transistor et non, comme c'est le cas dans US-4 590 434 et WO-A-80 02 484, quels que soient les gains des amplificateurs.

**Revendications**

1. Dispositif à large bande passante pour l'amplification d'un signal électrique, comportant des moyens d'entrée (L1) recevant ce signal, un amplificateur (T) à l'entrée duquel ces moyens (L1) sont reliés, des moyens (L12, Lm) pour réaliser une rétroaction entre un signal en sortie de l'amplificateur et le signal en entrée de celui-ci, les moyens d'entrée (L1) présentant une impédance self-inductive de résonance,
caractérisé en ce que les moyens de rétroaction comportent des moyens (L12) reliés à la sortie de l'amplificateur (T), qui sont couplés par induction mutuelle partielle (Lm) aux moyens d'entrée (L1) et qui atténuent, au moins en partie, le pic de résonance de la réponse en gain du dispositif au voisinage de la fréquence de coupure.

2. Dispositif selon la revendication 1, caractérisé en ce que les moyens de la rétroaction comportent également des moyens résistifs (Rctr1).

3. Dispositif selon l'une des revendications 1 ou 2, caractérisé en ce que le coefficient de couplage mutuel est compris entre 0,01 et 0,5.

4. Dispositif selon la revendication 3, caractérisé en ce que le coefficient de couplage mutuel est au voisinage de 0,1.

5. Dispositif selon l'une des revendications précédentes, caractérisé en ce qu'il est intégré à un composant monolithique.

6. Dispositif selon la revendication 5, caractérisé en ce que les moyens d'entrée (L1) comportent au moins un ruban inductif porté par un substrat et en ce que les moyens de rétroaction comportent au moins un ruban inductif (L12) porté par ce substrat à proximité du ruban inductif des moyens d'entrée (L1), la disposition relative et la géométrie de ces rubans assurant leur couplage mutuel partiel.

7. Dispositif selon la revendication 6, caractérisé en ce que le ruban inductif (L12) des moyens de rétroaction est une ligne s'étendant selon une géométrie qui épouse sensiblement, au moins en partie, celle du ruban inductif (L1) des moyens d'entrée.

8. Dispositif selon l'une des revendications 6 et 7, caractérisé en ce que le substrat est un substrat de quartz ou d'InP ou de GaAs.

9. Dispositif selon l'une des revendications précédentes, caractérisé en ce qu'il constitue un étage de préamplification d'un ensemble de traitement d'un signal lumineux, l'amplificateur (T) comportant au moins un transistor à effet de champ polarisé avec une tension de grille négative (Vg) et recevant sur sa grille le signal en sortie d'au moins une photodiode (Pd).

10. Utilisation d'un dispositif selon la revendication 9 pour la télécommunication optique.

**Patentansprüche**

1. Vorrichtung mit großer Übertragungsbandbreite für die Verstärkung eines elektrischen Signals, welche dieses Signal empfangende Eingangsmittel (L1), einen Verstärker (T), mit dessen Eingang diese Mittel (L1) verbunden sind, und Mittel (L12, Lm) zum Verwirklichen einer Rückkopplung zwischen einem Ausgangssignal des Verstärkers und dessen Eingangssignal aufweist, wobei die Eingangsmittel (L1) eine Selbstinduktions-Resonanzimpedanz aufweisen,
dadurch gekennzeichnet,
daß die Rückkopplungsmittel mit dem Ausgang des Verstärkers (T) verbundene Mittel (L12) aufweisen, die mittels einer teilweisen gegenseitigen Induktion (Lm) mit den Eingangsmitteln (L1) gekoppelt sind und die wenigstens teilweise den Resonanzpeak des Verstärkungsfaktorverlaufs der Vorrichtung in der Nähe der Grenzfrequenz dämpfen.

2. Vorrichtung nach Anspruch 1, dadurch gekennzeichnet, daß die Rückkopplungsmittel ebenfalls resistive Mittel (Rctrl) aufweisen.

3. Vorrichtung nach Anspruch 1 oder 2, dadurch gekennzeichnet, daß der Koeffizient der gegenseitigen Kopplung zwischen 0,01 und 0,5 liegt.

4. Vorrichtung nach Anspruch 3, dadurch gekennzeichnet, daß der Koeffizient der gegenseitigen Kopplung um 0,1 liegt.

5. Vorrichtung nach einem der vorhergehenden Ansprüche, dadurch gekennzeichnet, daß sie in ein monolithisches Bauteil integriert ist.

6. Vorrichtung nach Anspruch 5, dadurch gekennzeichnet, daß die Eingangsmittel (L1) wenigstens einen von einem Substrat getragenen induktiven Film bzw. Band aufweisen, und daß die Rückkopplungsmittel wenigstens einen induktiven Film bzw. Band (L12) aufweisen, der von diesem Substrat in der Nähe des induktiven Filmes der Eingangsmittel (L1) getragen wird, wobei die relative Anordnung und die Geometrie dieser Filme ihre teilweise gegenseitige Kopplung sicherstellen.

7. Vorrichtung nach Anspruch 6, dadurch gekennzeichnet, daß der induktive Film (L12) der Rückkopplungsmittel eine sich entlang einer Geometrie erstreckende Linie bzw. Leitung ist, die sich im wesentlichen, wenigstens teilweise, an diejenige des induktiven Filmes (L1) der Eingangsmittel anschmiegt bzw. anpaßt.

8. Vorrichtung nach Anspruch 6 oder 7, dadurch gekennzeichnet, daß das Substrat ein Quarz- oder InP- oder GaAs-Substrat ist.

9. Vorrichtung nach einem der vorhergehenden Ansprüche, dadurch gekennzeichnet, daß sie eine Vorverstärkungsstufe einer Lichtsignal-Verarbeitungsanordnung bildet, wobei der Verstärker (T) wenigstens einen Feldeffekt-Transistor aufweist, der mit einer negativen Gitterspannung (Vg) polarisiert ist und an seinem Gitter das Ausgangssignal wenigstens einer Fotodiode (Pd) empfängt.

10. Verwendung einer Vorrichtung nach Anspruch 9 für die optische Telekommunikation.

**Claims**

1. Wideband device for amplifying an electrical signal including input means (L1) receiving said signal, an amplifier (T) to the input of which said means (L1) are connected, and means (L12, Lm) for achieving feedback between a signal at the output of the amplifier and the signal at the input of the latter, the input means (L1) having a resonant self-inductive impedance,
characterised in that the feedback means include means (L12) connected to the output of the amplifier (T) coupled by mutual partial induction (Lm) to the input means (L1) and which at least partly attenuate the resonant peak in the gain response of the device in the vicinity of the cut-off frequency.

2. Device according to claim 1 characterised in that the feedback means also include resistive means (Rctr1).

3. Device according to claim 1 or claim 2 characterised in that the mutual coupling coefficient is in the range 0.01 to 0.5.

4. Device according to claim 3 characterised in that the mutual coupling coefficient is in the vicinity of 0.1.

5. Device according to any one of the preceding claims characterised in that it is integrated into a monolithic component.

6. Device according to claim 5 characterised in that the input means (L1) include at least one ribbon inductor carried by a substrate and in that the feedback means include at least one ribbon inductor (L12) carried by said substrate in the vicinity of the ribbon inductor of the input means (L1), the relative disposition and the geometry of said ribbons assuring their partial mutual coupling.

7.  Device according to claim 6 characterised in that the ribbon inductor (L12) of the feedback means is a line extending in a geometry which substantially espouses, at least in part, that of the ribbon inductor (L1) of the input means.

8.  Device according to claim 6 or claim 7 characterised in that the substrate is a quartz or InP or GaAs substrate.

9.  Device according to any one of the preceding claims characterised in that it constitutes a pre-amplifier stage of a light signal processing system, the amplifier (T) including at least one field-effect transistor biased with a negative gate voltage (Vg) and receiving on its gate the signal at the output of at least one photodiode (Pd).

10. Use of a device as claimed in claim 9 for optical telecommunication.

# FIG.1

# FIG.2

# FIG.3

# FIG.4

FIG.5

FIG.6a

FIG.6b

FIG.7

*FIG.8*

*FIG.9*

EP 0 656 685 B1